# EUROPÄISCHE PATENTSCHRIFT

(11) **EP 2 683 230 B1**
(45) Veröffentlichungstag und Bekanntmachung des Hinweises auf die Patenterteilung: **25.04.2018**
(21) Anmeldenummer: 13187075.0
(22) Anmeldetag: 03.08.2011
(51) Int. Cl.: H05K 7/14

(54) **KASTENGEHÄUSE**
BOX ENCLOSURE
COFFRET

(30) Priorität: 23.08.2010 DE 102010035100; 26.10.2010 DE 102010049605
(43) Veröffentlichungstag der Anmeldung: 08.01.2014
(62) Teilanmeldung aus: 11749374.2
(73) Patentinhaber: Rohde & Schwarz GmbH & Co. KG, 81671 München (DE)
(72) Erfinder: Muhr, Hermann, 94267 Prackenbach (DE); Fischl, Andreas, 94244 Geiersthal (DE); Kufer, Wolfgang, 84453 Mühldorf (DE); König, Hans-Dieter, 85540 Haar (DE); Hingrainer, Helmut, 83064 Raubling (DE)
(74) Vertreter: Körfer, Thomas

(56) Entgegenhaltungen:
- EP-A1- 1 463 399
- EP-A2- 1 791 412
- DE-A1- 4 309 084
- DE-A1- 19 833 248
- DE-U1- 9 006 503

## Beschreibung

Die Erfindung bezieht sich auf ein Kastengehäuse zum Einbau von elektronischen Baugruppen mit einer Unterteilung in Teilbereiche.

Das Dokument DE 196 03 368 A1 beschreibt ein Kastengehäuse für elektronische Messgeräte von derzeit üblicher Bauart. Das beschriebene Kastengehäuse besteht aus einem geschlossenen rechteckigen Rahmen, einer Montagewanne mit einem flachen Boden und davon rechtwinklig abstehenden schmalen Seitenwänden, die die Bedienelemente des Geräts aufnehmen, sowie einer Fronthaube, die über die Montagewanne gestülpt wird und die Frontseite des Kastengehäuses bildet. Rückseitig ist auf den Rahmen ein Baugruppenträger angesetzt, der aus Blechteilen zu einem auf mindestens einer Seite offenen Kasten zusammengesetzt ist und in dem die einzelnen Baugruppen eingesetzt werden. Auf den Baugruppenträger ist von hinten ein Gehäusetubus aufschiebbar, der vorne und hinten offen ist und aus Blech durch Biegen hergestellt ist. Zur hochfrequenzdichten Abschirmung ist eine umlaufende Ringnut an einem Kontaktsteg ausgebildet, in die eine Metallgeflechtschnur eingesetzt werden kann.

Nachteilig an dem beschriebenen Kastengehäuse ist der hohe Platzbedarf zum Abziehen des Gehäusetubusses und somit die schlechte Zugänglichkeit, insbesondere wenn das Gehäuse bereits in ein Rack eingebaut ist. Ein z. B. auf Teleskopschienen montiertes Gehäuse muss von den Teleskopschienen gelöst werden, um den Gehäusetubus abziehen zu können. Elektronische Baugruppen werden somit meist von der Geräterückseite aus in Richtung Frontplatte eingebaut, um dieses umständliche Öffnen des Gehäuses beim Wechsel von Baugruppen zu vermeiden. Außerdem wäre es wünschenswert innerhalb des Gehäuses Teilbereiche, die durch Trennwände begrenzt sind, auszubilden und so Baugruppen von unterschiedlichem Typ getrennt gruppieren zu können.

Die EP 1 791 412 A2 beschreibt ein Kopf- oder Bodenteil eines Baugruppenträgers mit nebeneinander angeordneten und in Einschubrichtung ausgerichteten Führungsschienen zur Aufnahme einer Leiterplatte einer Steckbaugruppe. Pro Führungsschiene sind zwei Reihen von Führungsstegen vorgesehen, die einfach ausgestanzt und hochgekantet sind. Dabei verbleibt neben dem Führungssteg eine Aussparung.

Die DE 198 33 248 A1 beschreibt ein Gerätechassis aus Metallblech. Das aus Blechteilen zu einem auf mindestens einer Seite offenen Kasten zusammengesetzte Chassis besteht aus einem Bodenblech und zwei gegenüberliegenden Seitenblechwänden sowie einer Rückwand. In dieses Chassis sind parallel hintereinander mehrere in gedruckter Schaltungstechnik ausgebildete Leiterplatten eingesetzt. Auf den Innenseiten der Seitenwände sind Führungsnuten für die Leiterplatten ausgebildet, in welche die seitlichen Ränder der Leiterplatten von oben einschiebbar sind, bis die am unteren Rand der Leiterplatten ausgebildete Kontaktleiste mit der am Boden ausgebildeten Kontaktleiste in Kontakt steht.

Die DE 90 06 503 U1 beschreibt eine Gerätewand mit Führungsbahnen für Einschub-Baugruppenträger. Die Gerätewand umfasst aus der Wandebene ausgestanzte und ausgebogene Bördelränder, welche Führungsbahnen für Einschub-Baugruppenträger begrenzen. Die Führungsbahnen sind zumindest an einer Seite jeweils durch mehrere in Einschubrichtung hintereinander angeordnete Stanzlöcher gesäumt, deren Bördelränder die Führungsbahnen tangieren.

Die DE 43 09 084 A1 beschreibt ein störstrahlsicheres Gehäuse mit einem Gehäusemantel, einer Rückwandleiterplatte und einem Frontdeckel zum Verschliessen der Frontseite. Der Gehäusemantel ist aus zwei identisch aufgebauten, U-förmigen Gehäuseschalen gebildet, deren stirnseitige Schenkelenden mit ebenen und abgewinkelten Vorsprüngen versehen sind, die unter Bildung von Stossfugen ineinander greifen und miteinander verbunden sind. Der Frontdeckel besteht aus einer Lochplatte, die aussen mit einer durchsichtigen Scheibe abgedeckt ist.

Die EP 1 463 399 A1 beschreibt ein Gehäuse einer elektronischen Vorrichtung. Dieses umfasst einen ersten Gehäuseabschnitt in Kastenform und mit einer Öffnung auf einer Ebene, und einen zweiten Gehäuseabschnitt, welcher die Öffnung verschließt. Der erste und der zweite Gehäuseabschnitt sind aus Plattenbauteilen mit einer beschichteten Oberfläche und einer unbeschichteten Oberfläche hergestellt, wobei die beschichtete Oberfläche als Außenfläche und die nicht beschichtete Oberfläche als Innenfläche verwendet wird. Der erste Gehäuseabschnitt umfasst eine senkrechte Seitenwand und einen waagerechten Kontaktabschnitt, der sich von einer Oberkante der senkrechten Seitenwand in einer waagerechten Richtung erstreckt. Der waagerechte Kontaktabschnitt weist ein gefaltetes Teilstück auf, das durch den waagerechten Kontaktabschnitt verläuft und durch Falten eines Abschnitts des waagerechten Kontaktabschnitts zur Ausbildung der unbeschichteten Oberfläche als ein Abschnitt einer oberen Fläche des waagerechten Kontaktabschnitts gebildet wird. Das gefaltete Teilstück weist eine Vielzahl von Kontaktabschnitten auf, die in Kontakt mit der Innenfläche des zweiten Gehäuseabschnitts stehen, um eine elektromagnetische Welle abzuschirmen.

Es ist daher die Aufgabe der vorliegenden Erfindung ein Gehäuse für elektronische Baugruppen mit verschiedenen Unterteilungen in Teilbereiche und ein entsprechendes Herstellungsverfahren zu schaffen, das einfach und kostengünstig herstellbar ist, sowie für die Bestückung und Wartung einfach zugänglich ist.

Die Aufgabe wird durch das erfindungsgemäße Kastengehäuse gemäß Anspruch 1 gelöst. In den Unteransprüchen sind vorteilhafte Weiterbildungen des erfindungsgemäßen Kastengehäuses dargestellt.

Das erfindungsgemäße Kastengehäuse zum Einbau von elektronischen Baugruppen hat Rahmenelemente und Seitenwände und weist eine Unterteilung in Teilbereiche auf, die durch Trennwände begrenzt sind, wobei die Rahmenelemente sowie die Seiten- und Trennwände mindestens eine Ausnehmung und/oder mindestens einen randseitigen Überstand aufweisen, ein Überstand in eine Ausnehmung eingreift und der Überstand und die Ausnehmung durch Schweißen miteinander verbunden sind. Vorteilhafterweise können durch die Platzierung der Ausnehmungen und der entsprechenden randseitigen Überstände unterschiedlichste Unterteilungen des Kastengehäuses erzielt werden. Die einzelnen Seiten- und Trennwände sind einfach zusammensteckbar und bilden bereits vor dem Schweißvorgang ein stabiles Gebilde. Dies vereinfacht das Einspannen der Einzelteile zur Vorbereitung für den darauffolgenden Schweißvorgang. Daraus ergibt sich eine kurze Vorspannzeit und somit eine zeitoptimierte Montage.

Vorteilhafterweise weist ein Zwischenraum zwischen dem Überstand und einem Rand der Ausnehmung, in die der Überstand eingreift, eine Breite von weniger als 100 µm, bevorzugt weniger als 50 µm Breite auf. Die daraus resultierenden Toleranzen für die Größe des Überstands sowie der Ausnehmungen sind mit der derzeit üblichen Stanz- oder Laserschneidtechnik ohne weiteres erreichbar. Somit kann zur Fertigung des Kastengehäuses die übliche Stanz- oder Schneidetechniken eingesetzt werden und erlaubt eine kostengünstige Herstellung.

Vorteilhafterweise sind die Deckenplatte und die Bodenplatte durch Einschieben in Aufnahmeöffnungen in den Seitenwänden lösbar befestigt. Die Seiten- und/oder Trennwand weist einen Stirnfalz mit einem ersten und zweiten zueinander geneigten Schenkel auf, wobei im ersten Schenkel Aufnahmeöffnungen für die Deck- bzw. Bodenplatte vorgesehen sind. Somit kann Deck- und Bodenplatte separat vom Kastengehäuse nach oben oder unten abgenommen werden. Das Gehäuse kann dabei z. B. auf Teleskopschienen montiert in einem Rack verbleiben. Außerdem sind keine Werkzeuge, z. B. Schraubendreher etc., zum Lösen der Deck- oder Bodenplatte notwendig, so dass lediglich ein geringer freier Raum zum Öffnen des Kastengehäuses notwendig ist.

Von Vorteil ist auch, dass eine Seiten- und/oder eine Trennwand eine Mehrzahl von Führungsöffnungen mit überstehenden Kragen aufweist, wobei die Führungsöffnungen auf zwei parallelen Geraden in einem Abstand voneinander parallel zur Einschubrichtung einer elektronischen Baugruppe an der Seiten- oder Trennwand angeordnet sind. Somit können elektronische Baugruppen entlang der überstehenden Kragen geführt zu ihrem Steckplatz geführt werden. Zusätzlich gewährleisten die Führungsöffnungen eine gute Belüftung auch der hinter einer Trennwand liegenden Baugruppe und somit einen durchgängigen Luftstrom durch die verschiedenen Teilbereiche des Gehäuses hindurch.

Vorteilhafterweise weist der Kragen einer Führungsöffnung eine runde Kontur auf. Dies ermöglicht ein leichtes und beschädigungsfreies Einführen einer Baugruppe, insbesondere der Platine einer Baugruppe.

Vorteilhafterweise ist mindestens ein Federelement lösbar mit einer Seiten- und/oder Trennwand verbunden und so angeordnet, dass es in den durch die beabstandeten Führungsöffnungen begrenzten Bereich einhakt. Insbesondere wird das Federelement in eine Ausnehmung der Seiten- und/oder Trennwand eingeschoben. Somit kann die Position des Federelements in den durch die beabstandeten Führungsöffnungen begrenzten Bereich variabel eingestellt werden und eine Baugruppe bzw. die in ihr enthaltene Platine in der Höhe so gehalten werden, dass der Anschluss der Baugruppe exakt in den dafür vorgesehenen Stecker eingeführt wird. Somit kann der Abstand zwischen den durch die Führungsöffnungen begrenzten Bereich weiter gewählt werden, so dass Baugruppen mit unterschiedlich dicken Platinen einführbar sind und dennoch der Stecker beim Einsetzen der Baugruppe exakt getroffen wird. Somit werden Stecker und Baugruppe mechanisch wenig belastet und die Lebensdauer der Baugruppe positiv beeinflusst. Vorteilhafterweise ist mindestens eine Zentriernase im Randbereich der Seiten- und/oder Trennwand angeordnet, in die eine Ausnehmung in einem Baugruppengehäuse eingreift. Somit wird eine Ausrichtung der Baugruppe an der dem Stecker gegenüberliegenden Seite der Baugruppe erreicht und ein Bewegungsspiel der Baugruppe minimiert. Weiterhin werden in einem ersten Teilbereich des Kastengehäuses eine erste Baugruppe oder mehrere erste Baugruppen senkrecht zur Ebene der Seitenwand eingebaut und in einem zweiten Teilbereich eine zweite Baugruppe oder mehrere zweite Baugruppen senkrecht zur Seitenwand und senkrecht zur ersten Baugruppe im ersten Teilbereich eingebaut. Dies ermöglicht eine Gruppierung ähnlicher Baugruppentypen, z. B. Hochfrequenz- oder digitale Schaltungsbaugruppen, in einem Teilbereich des Gehäuses. Vorkehrungen zur elektromagnetischen Abschirmung oder zur Anbindung an Datenverbindungen können somit effektiv auf die Bedürfnisse des Baugruppentyps in einem Teilbereich angepasst werden. Dabei können gezielt Trennwände zur elektromagnetischen Abschirmung der Baugruppentypen voneinander angebracht werden. Dies reicht in den meisten Fällen aus, insbesondere wenn z.B. jede Hochfrequenzbaugruppe bereits von einem hochfrequenzdichten Chassis umgeben ist.

Es ist außerdem vorteilhaft, wenn eine erste Baugruppe oder mehrere erste Baugruppen in ein erstes Grundrechnermodul eingesteckt sind, die eine zweite Baugruppe oder mehrere zweite Baugruppen in ein zweites Grundrechnermodul eingesteckt sind und das erste Grundrechnermodul parallel zur Steckrichtung der zweiten Baugruppe sowie das zweite Grundrechnermodul parallel zur Streckrichtung der ersten Baugruppe angeordnet ist.
Vorteilhaft ist weiterhin, dass das erste Grundrechnermodul und das zweite Grundrechnermodul durch eine Steckverbindung miteinander verbunden sind.

Diese Anordnung der Grundrechnermodule und der darin eingesteckten Baugruppen weist jeweils senkrecht zur Seitenwand liegende Freiräume zwischen den Baugruppen auf und ermöglicht somit eine effektive Belüftung durch einen durchgängigen Luftstrom von einer Seitenwand durch die Zwischenräume zwischen den Baugruppen hindurch zur anderen Seitenwand. Es werden lediglich Steckverbindungen zur Kontaktierung der Baugruppen mit dem jeweiligen Grundrechnermodul sowie zwischen dem ersten und dem zweiten Grundrechnermodul verwendet, so dass die Zwischenräume zwischen den Baugruppen nicht durch Kabel ausgefüllt sind und den Luftstrom behindern. Außerdem bildet die Steckverbindung zwischen den beiden Grundrechnermodul eine platzsparende und effektive Verbindung.

Mit dem erfindungsgemäßen Verfahren zur Herstellung eines Kastengehäuses mit Rahmenelementen und Seitenwänden, das in Teilbereiche unterteilt ist, die durch Trennwände begrenzt sind, wird mindestens eine Ausnehmung und/oder mindestens ein randseitiger Überstand in den Seiten- und Trennwänden eingebracht. Die Seitenwände und Trennwände werden zusammengefügt, indem ein Überstand in eine Ausnehmung eingreift und der Überstand und die Ausnehmung durch Schweißen miteinander verbunden werden.

Es ist insbesondere vorteilhaft, wenn die Seiten- und/oder Trennwände eine oder mehrere Lüftungszonen mit jeweils einer Vielzahl von Lüftungsöffnungen aufweisen und im Bereich der Lüftungszone eine Querprägung quer zu einem Rand der Seiten- und/oder Trennwand in die Seiten- und/oder Trennwand eingebracht wird. Dies verhindert ein Durchbiegen oder Wellen der Seitenwand durch Ausstanzen der Lüftungsöffnungen und fördert die Stabilität des Kastengehäuses.

Es ist ebenfalls vorteilhaft, wenn alle Ausnehmungen, Überstände, Aufnahme-, Führungs- und Lüftungsöffnungen mittels Stanzen und die Führungsnasen mittels Prägen eingebracht werden. Somit sind in einem bzw. zwei Arbeitsgängen alle Führungs- und Befestigungsöffnungen herstellbar. Dies ermöglicht eine kurze Herstellzeit mit gängiger Verfahrenstechnik und ist somit kostengünstig. Unterschiedliche Kastengehäuse-Varianten können einfach durch eine veränderte Positionierung der Ausnehmungen und randseitigen Überstände hergestellt werden.

Ausführungsbeispiele des erfindungsgemäßen Kastengehäuses sind in den Zeichnungen beispielhaft dargestellt und werden anhand der nachfolgenden Beschreibung näher erläutert. Es zeigen:
- Fig. 1: ein Ausführungsbeispiel eines erfindungsgemäßen Kastengehäuses in Explosionsdarstellung;
- Fig. 2: ein Ausführungsbeispiel einer Fronthaube eines erfindungsgemäßen Kastengehäuses in Seitenansicht;
- Fig. 3: ein Ausführungsbeispiel eines Seitenelements eines erfindungsgemäßen Kastengehäuses;
- Fig. 4: ein Ausführungsbeispiel einer erfindungsgemäßes Verbindung zwischen Seiten- und/oder Trennwänden mit einem Rahmenelement in perspektivischer Ansicht;
- Fig. 5: eine vergrößerte Darstellung einer erfindungsgemäßen Verbindung zwischen einer Seiten- und/oder Trennwand und einem Rahmenelement entsprechend Fig.4 in Seitenansicht;
- Fig. 6: eine erfindungsgemäße Verbindung entsprechend Fig. 5 in Draufsicht;
- Fig. 7: ein Ausführungsbeispiel der Verbindung zwischen Deckenplatte und Seitenwand eines erfindungsgemäßen Kastengehäuses in perspektivischer Ansicht;
- Fig. 8: ein erstes Ausführungsbeispiel eines ersten Federbandes eines erfindungsgemäßen Kastengehäuses in perspektivischer Ansicht;
- Fig. 9: ein Ausführungsbeispiel einer Seitenwand mit Federband entsprechend Fig.8 eines erfindungsgemäßen Kastengehäuses;
- Fig. 10: ein zweites Ausführungsbeispiel eines erfindungsgemäßen Federbandes in perspektivischer Ansicht;
- Fig. 11: das zweite Ausführungsbeispiel eines erfindungsgemäßen Federbandes eingebaut in ein Rahmenelement in Seitenansicht;
- Fig. 12: ein drittes Ausführungsbeispiel eines erfindungsgemäßen Federbandes eingebaut in ein Rahmenelement in Seitenansicht;
- Fig. 13: ein Ausführungsbeispiel einer Führungsanordnung für Baugruppen eines erfindungsgemäßen Kastengehäuses in Seitenansicht;
- Fig. 14: eine Baugruppenführungsanordnung entsprechend Fig. 13 in perspektivischer Ansicht;
- Fig. 15: ein erstes Ausführungsbeispiel einer Zentriervorrichtung des erfindungsgemäßen Kastengehäuses in perspektivischer Ansicht;
- Fig. 16: ein zweites Ausführungsbeispiel einer Zentriervorrichtung des erfindungsgemäßen Kastengehäuses in perspektivischer Ansicht;
- Fig. 17: ein Ausführungsbeispiel einer Baugruppenanordnung im erfindungsgemäßen Kastengehäuse in perspektivischer Ansicht und
- Fig. 18: ein Ausführungsbeispiel einer Seiten- oder Trennwand mit Lüftungszone mit Prägestempel in Draufsicht.

Einander entsprechende Teile sind in allen Figuren mit dem gleichen Bezugszeichen versehen.

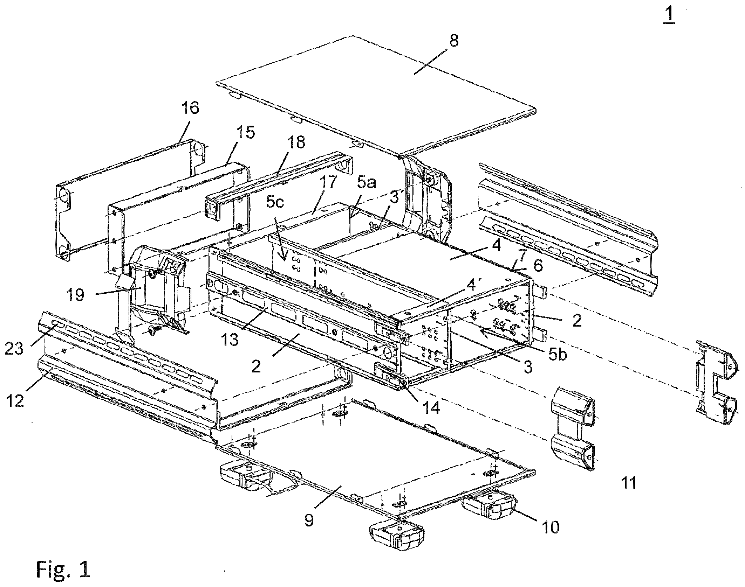

Fig. 1 zeigt einen Überblick über die Komponenten eines erfindungsgemäßen Kastengehäuses 1. Der Grundkörper des Gehäuses besitzt zwei Seitenwänden 2, eine oder mehrere Trennwände 3 sowie Rahmenelemente 4, die als flächige Rahmenelemente 4 oder stegförmige Rahmenelemente 4' oder aber als Frontrahmenelement 17 ausgeprägt sein können. Durch die entweder parallel zur Seitenwand 2 ausgerichteten Trennwände 3 und/oder senkrecht zur Seitenwand 2 ausgerichteten Trennwand 3' entstehen unterschiedliche Teilbereiche 5a, 5b, 5c im Kastengehäuse. Die Seiten- und Trennwände sowie die Rahmenelemente sowie eine Decken- und eine Bodenplatte 8, 9 sind aus einem metallischen Blech, bevorzugt einem Edelstahlblech, gefertigt.

Die Deckenplatte 8 sowie die Bodenplatte 9 schließen den Gehäusegrundkörper ab. Durch eine metallische Verbindung zwischen dieser Decken- und Bodenplatte 8, 9 und zwischen den Seiten- bzw. Trennwänden werden die in die Teilbereiche eingeschobenen Bauelemente zusätzlich elektromagnetisch abgeschirmt. Das Gehäuse selbst muss nur bedingt elektromagnetische Abschirmfunktion aufweisen, da die einzelnen Baugruppen selbst in elektromagnetisch dichten Chassis implementiert sind.

An das Frontrahmenelement 17 anschließend ist über eine Rastschiene 18 eine Montagewanne 15 sowie eine Frontplatte 16 montiert. Die nach außen weisende Oberfläche der beiden Seitenwände 2 weist jeweils eine Befestigungsschiene 13 auf, an der eine Seitenverkleidung 12 und optional daran anschließend seitliche Griffe oder Teleskopschienen montiert werden. Die Seitenverkleidung weist Lüftungsöffnungen 19 auf, um die Zu- bzw. Abfuhr von Luft in das Gehäuse zu Kühlungszwecken zu ermöglichen. An der Seitenverkleidung 12 und/oder dem Frontrahmenelement 17 können Fronttragegriffe 19 befestigt werden.

Am rückseitigen Ende der Seitenwände 2 ist ein weiteres Befestigungselementen 14 angebracht, an dem z.B. ein Rückwandfuß 11 befestigt ist, der als Stoßschutz und als Abstandhalter für die Montage von Anschlüssen und Steckern dient. Ein nicht in einem Rack eingebautes Gerät kann auf diese Rückwandfüße 11 auch abgestellt werden. Zusätzlich können Aufstellfüße 10 an der Bodenplatte 9 des Kastengehäuses angebracht sein, um das Messgerät in einem Rack z.B. auf einen Regalboden aufstellen zu können. Die genannten Füße 9 bzw. 11 müssen zum Öffnen des Gehäuses abmontiert werden.

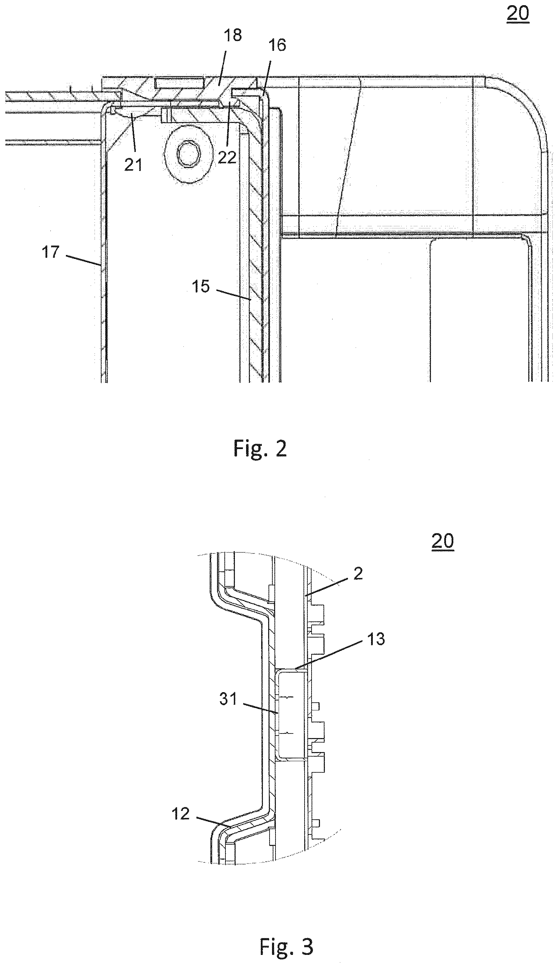

Fig. 2 zeigt eine vergrößerte Darstellung einer Fronthaube 20 bestehend aus der Frontplatte 16 und der Montagewanne 15. Diese Fronthaube 20 ist über eine Rastschiene 18 mit dem Frontrahmenelement 17 verbunden. Dazu ist die Frontplatte 16 durch ein frontseitiges Rastelement 22 der Rastschiene 18 mit der Montagewanne 15 verbunden. Über ein Gehäuse-seitiges Rastelement 21, das unter das Frontrahmenelement 17 mit seiner Nase greift, wird die Fronthaube 20 mit dem Frontrahmenelement 17 verbunden. Seitlich über die Fronthaube 20 ragt der Fronttragegriff 19 hervor, der zum Herausziehen des Messgeräts aus einem Rack Verwendung findet.

Fig. 3 zeigt ein Seitenelement des Kastengehäuses umfassend eine Seitenwand 2, eine Befestigungsschiene 13 sowie eine daran montierte Seitenverkleidung 12. Die Befestigungsschiene 13 besteht vorzugsweise ebenfalls aus einem Edelstahlblech und weist größere Ausnehmungen 31 auf, um Gewicht einzusparen. Die Befestigungsschiene 13 stabilisiert das Kastengehäuse 1 und dient als Befestigungsbasis für die Seitenverkleidung 12 sowie weitere Komponenten wie Tragegriff oder Teleskopschienen.

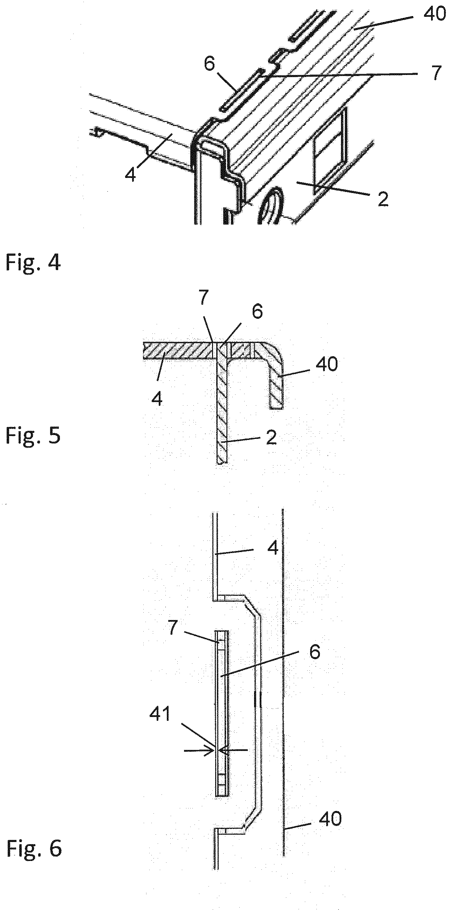

Fig. 4 zeigt einen vergrößerten Ausschnitt der Verbindung zwischen einem deckenseitigen Rahmenelement 4 und einer Seitenwand 2. Das vorzugsweise aus Edelstahlblech hergestellte Rahmenelement 4 weist im Randbereich mindestens eine Ausnehmung 7 auf. Entsprechend ist im Randbereich der Seitenwand 2 integriert in ein Abschlusselement 40 mindestens einen Überstand 6 vorhanden, der zu einer Steckverbindung zusammengefügt ist und durch Schweißen stoffschlüssig mit der Ausnehmung 7 verbunden ist.

In den Figuren 5 und 6 ist diese Steckverbindung in Seitenansicht und in Draufsicht vergrößert dargestellt. Die Seitenwand 2 weist in regelmäßigen Abständen einen Überstand 6 auf, der entsprechend der Stärke des Rahmenelements 4 über die Höhe der Seitenwand 2 übersteht. Der Überstand 6 greift in eine Ausnehmung 7 des deckenseitigen Rahmenelements 4 ein.

Wie in Fig. 6 deutlich zu erkennen, bleibt lediglich ein schmaler Zwischenraum 41 zwischen der Ausnehmung 7 und dem Überstand 6 bestehen. Vorzugsweise werden die Ausnehmungen durch Stanzen oder Laserschneiden hergestellt, sodass der Zwischenraum 41 weniger als 100µm, vorzugsweise weniger als 50pm, Breite misst. Die Seiten- und Trennwände 2,3 sowie die Rahmenelemente 4, 4', 17 lassen sich somit bereits stabil, nur durch Stecken, miteinander verbinden, sodass nunmehr geringe Einspannmaßnahmen für den nachfolgenden Schweißvorgang notwendig sind. Durch den schmalen Zwischenraum 41 verbindet sich sehr schnell das Material des Überstandes mit dem angrenzenden Material des Rahmenelements, sodass der Schweißvorgang schnell und mit geringer Energie ausführbar ist.

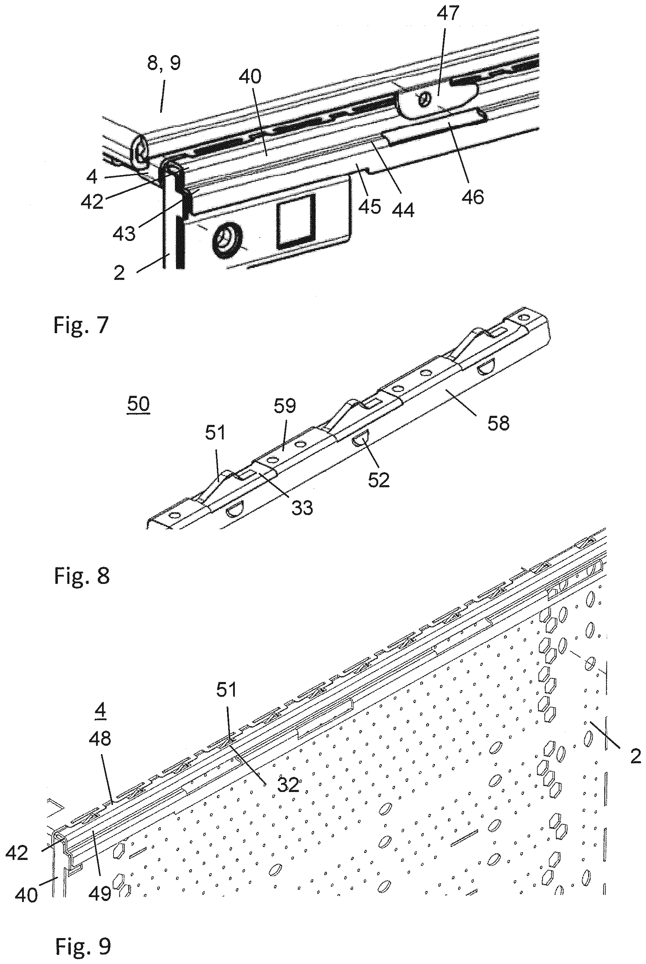

In Fig. 7 ist die Verbindung zwischen einer Seitenwand 2 mit einem flächigen Rahmenelement 4 und insbesondere mit der darüber liegenden Decken- bzw. Bodenplatte 8, 9 dargestellt. Die Seitenwand 2 weist, wie schon in Fig. 4 dargestellt, ein Abschlusselement 40 auf, das zu einem ersten und zweiten Stirnfalz 42, 43 ausgeformt ist. Jeder Stirnfalz 42, 43 weist einen ersten Schenkel 44 und einen zweiten Schenkel 45 auf, der um 90 Grad zum ersten Schenkel 44 gebogen ist. Um die Decken- bzw. Bodenplatte 8, 9 mit geringem Platzbedarf vom Gehäuse lösen zu können, weist die Decken- bzw. Bodenplatte 8, 9 randseitig über ihre Länge verteilt mehrere senkrecht von der Decken- bzw. Bodenplatte 8, 9 überstehende Haken 47 auf, die in Aufnahmeöffnungen 46 im ersten Schenkel 44 des zweiten Stirnfalz 43 eingeschoben werden. Der schräg von der Decken- bzw. Bodenplatte 8, 9 weglaufende Haken sorgt beim Einschieben für eine Vorspannung zwischen Haken 47 und dem ersten Schenkel 44 des Abschlusselementes, sodass die Deckenplatte nicht nur Verrutsch-sicher fixiert ist, sondern auch ein guter elektrischer Kontakt zwischen Seitenwand 2 und Decken- bzw. Bodenplatte 8, 9 gewährleistet ist.

Um den elektrischen Kontakt zwischen Seiten- bzw. Trennwand 2,3 und Decken- bzw. Bodenplatte 8, 9 noch zu verbessern, kann ein erstes Ausführungsbeispiel eines Federbandes 50, siehe Fig. 8, in den ersten Stirnfalz 42 des Abschlusselements 40 der Seiten- bzw. Trennwand 2, 3 , wie in Fig. 9 dargestellt, eingebracht werden. Dazu weist der erste Schenkel 48 des ersten Stirnfalzes 42 Ausnehmungen 32 auf, durch die Federzungen 51 des von unten in den ersten Stirnfalz 42 eingeschobenen Federbands 50 hindurchtreten und einen elektrischen Kontakt zur Decken- bzw. Bodenplatte 8, 9 herstellen.

Das in Fig. 8 separat dargestellte Federband 50 wird vorzugsweise aus einem Blechteil hergestellt und weist an einer Stirnseite 59, die zwischen nach unten gebogenen Seitenarmen 58 liegt, Federzungen 51 auf. Die Federzungen 51 sind ebenfalls schmale gebogene Metallstreifen, die an der Stirnseite 59 des Federbandes 50 befestigt sind und in Ausnehmungen 33 in der Stirnseite 59 hineinragen. Das Federband 50 wird durch Halteelemente 52, die beispielsweise durch Einschneiden eines halbkreisförmigen Bogens in die Seitenarme 58 des Federbandes 50 und Hochbiegen des ausgeschnittenen Bereich entstehen, in nicht dargestellten Ausnehmungen in der zweiten Stufe 49 des ersten Stirnfalzes 42 der Seiten- bzw. Trennwand 2,3 vor Verrutschen gesichert.

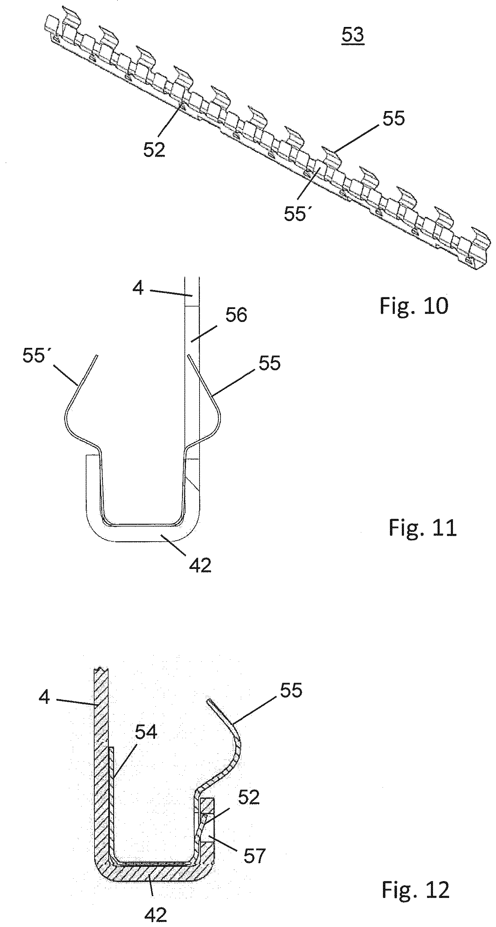

Fig. 10 zeigt ein weiteres Ausführungsbeispiel eines Federbandes 53, das in ähnlicher Weise wie Federband 50 vorzugsweise durch Stanzen und Biegen hergestellt ist. Dieses Federband 53 wird bevorzugt zwischen der Decken- und Bodenplatte 8,9 und dem rückseitigen Rahmenelement 4' bzw. 4 eingesetzt. Das Federband 53 wird ebenfalls über Halteelemente 52 in einem Falz des Rahmenelements 4' bzw. 4 fixiert. Dabei treten die Federelemente 55 in Richtung Decken- bzw. Bodenplatte 8,9 durch Ausnehmungen im Rahmenelement 4, 4' über dieses hervor und bilden einen elektrischen Kontakt zur Decken- bzw. Bodenplatte 8,9. Die in das Innere des Kastengehäuse hineinragenden Federelemente 55' dienen zur elektrischen Kontaktierung eingeschobener Baugruppen bzw. deren Rückwand.

Fig. 11 zeigt das Federband 53 eingebaut in einen Stirnfalz 42 des Rahmenelements 4. Das Federelement 55 tritt durch die Ausnehmung 56 des Rahmenelements 4 hindurch, wohingegen das Federelement 55' zur entgegengesetzten Seite hin weist.

Fig. 12 zeigt ein drittes Ausführungsbeispiel eines Federbands 54, mit einem lediglich nach einer Seite abstehenden Federelement 55. Dieses ist in gleicher Weise wie Federband 53 in Fig. 11 in einen Stirnfalz 42 eines Rahmenelements 4 eingesetzt und wird durch das Halteelement 52 in der Ausnehmung 57 gehalten. Das Halteelement 52 rastet in die Ausnehmung 57 ein und verhindert somit ein Zurückrutschen aus dem Falz heraus. Durch die Breite des Halteelements 52 sowie die Breite der Ausnehmung 57 ist lediglich eine geringe Verschiebung in Längsrichtung des Federbandes 54 möglich.

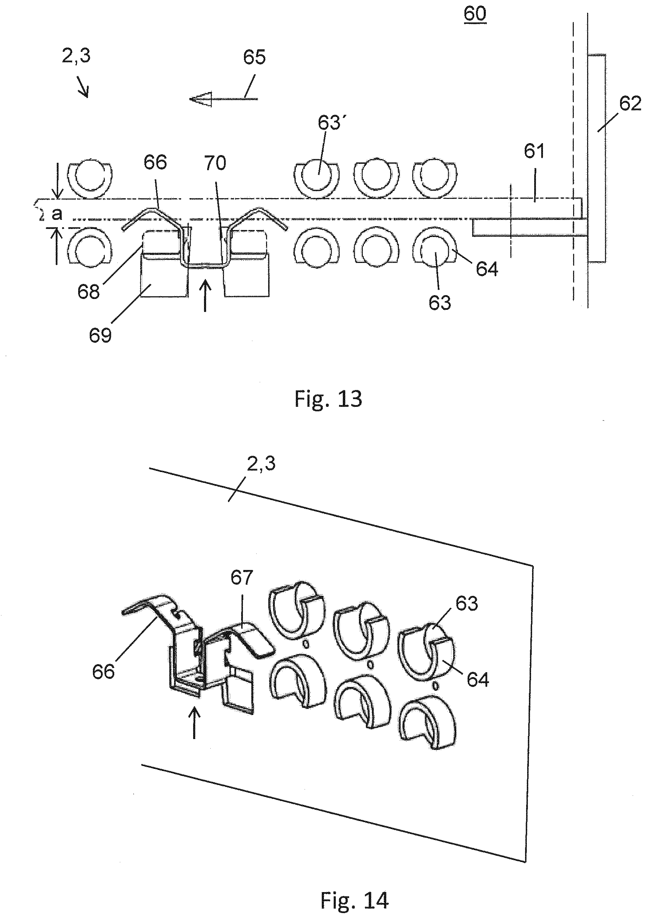

Fig. 13 und Fig. 14 stellt eine Führungsanordnung 60 zum Platzieren von Baugruppen in den Teilbereichen des Kastengehäuses dar. Im Blick auf eine Seiten- oder Trennwand 2, 3 sind Führungsöffnungen 63 erkennbar, die einen Kragen 64 aufweisen. Die Führungsöffnungen 63 sind in zwei Reihen parallel zueinander angeordnet, wobei die Krägen 64 zueinander weisen. Der Abstand a, in Figur 13 links dargestellt, ist dabei so groß, dass Platinen 61 mit unterschiedlicher Stärke zwischen den Krägen eingeschoben werden können. Durch die abgerundete Form, hier zum Beispiel Kreissegmente, der Krägen 64 ist die Platine 61 einer Baugruppe leicht und ohne Beschädigung in Einschubrichtung 65 einschiebbar. Die Platine 61 selbst ist dabei an einer Baugruppenrückwand 62 montiert. Um einen festen Sitz der Platine 61 zwischen den Führungsöffnungen zu gewährleisten, ist eine ohne mehrere Federn 67 in Aufnahmeöffnungen 69 leicht unterhalb der Führungsöffnungen 63 einsetzbar. Die Aufnahmeöffnung 69 weist neben einem großflächigen Bereich einen seitlichen Hals auf, der zusätzlich eine Engstelle 70 aufweist. Halteflügel 68, die seitlich von der Feder abstehen, werden in die Aufnahmeöffnung 69 eingeführt und in Richtung der Platine 61, siehe Pfeil, geschoben. Durch die Engstelle 70 in der Aufnahmeöffnung 69 wird ein Zurückrutschen der Feder 67 verhindert. Lediglich durch Zusammendrücken der Feder 67 kann diese wieder von der Seiten- oder Trennwand 2, 3 entfernt werden.

Die Feder 67 übt auf die Platine einen leichten Anpressdruck aus und hält diese fest an die gegenüber angeordneten Führungsöffnungen 63' an. Somit hat die Platine 61 keinen Bewegungsspielraum mehr bzw. kann bei einem kräftigen Stoß in der Bewegung abgefedert werden.

Die Feder 67 kann bereits vor dem Einschieben der Platine an der Seiten- oder Trennwand 2, 3 montiert sein. Beim Einschieben der Platine 61 in Einschubrichtung 65 wird das nach unten gekrümmte Federelement 66 nach unten gedrückt und lässt die Platine 61 passieren. Der Pfeil in Fig. 14 zeigt die Montagerichtung der Feder 66 an der Seiten- bzw. Trennwand 2, 3. Die Führungsöffnung 63 ist hier in einem auf der gesamten Umfangslänge gleichbleibend hohen Kragen 64 dargestellt. Der Kragen 64 kann jedoch auch auf der von der Platine 61 wegzeigenden Seite niedriger auslaufen. Der Kragen 64 wird bevorzugt durch Ausstanzen bzw. Umbiegen der Seiten- bzw. Trennwand 2,3 hergestellt.

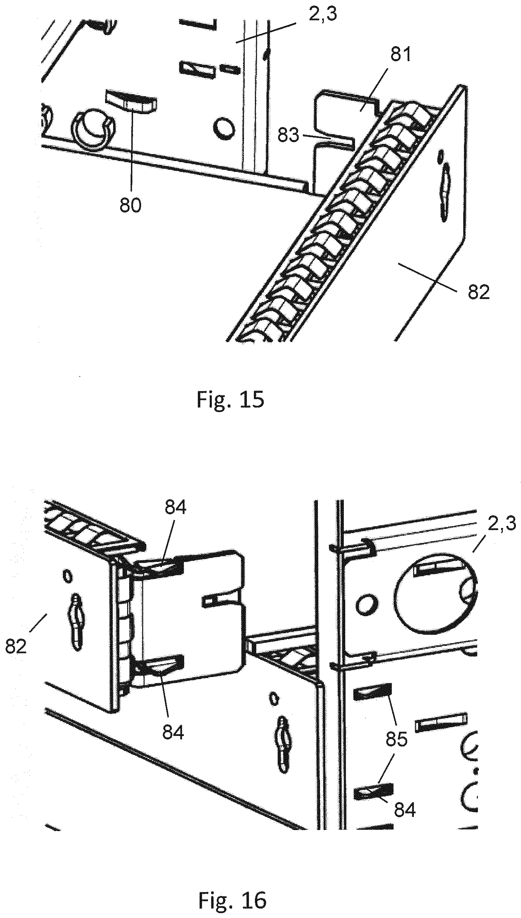

Fig. 15 zeigt eine Zentriernase 80 in einer Seiten- oder Trennwand 2, 3. Die Zentriernase 80 ist in einem geringen Abstand von der Rückseite an der Seiten- bzw. Trennwand 2,3 angeordnet und durch Stanzen und Aufbiegen der Seiten- bzw. Trennwand 2, 3 hergestellt. Eine von der Rückwand 82 einer Baugruppe abstehende Seitenblende 81 weist einen Zentrierschlitz 83 auf, der beim Einschieben der Baugruppe die Zentriernase 80 umschließt. Durch diese Höhenfixierung der Baugruppe kann sichergestellt werden, dass ein Stecker an der Vorderseite der Baugruppe auf passender Höhe mit dem Gegensteckerteil liegt.

In Fig. 16 ist eine weitere Zentrieranordnung, die auch zum Arretieren einer Baugruppe am Gehäuse dient, dargestellt. In dieser Anordnung sind zwei Arretiernasen 84 am oberen und unteren Rand der Seitenblende 81 des Baugruppenrückwand 82 federnd angebracht. Beim Einschieben der Baugruppenrückwand 82 rasten diese Arretiernasen 84 in die entsprechenden Ausnehmungen 85 in der Seiten- bzw. Trennwand 2,3 ein. Da die Arretiernasen 85 entgegen der Einschubrichtung nicht zurückfedern, kann die Baugruppe nur noch mit Hilfsmitteln aus dem Kastengehäuse 1 gelöst werden.

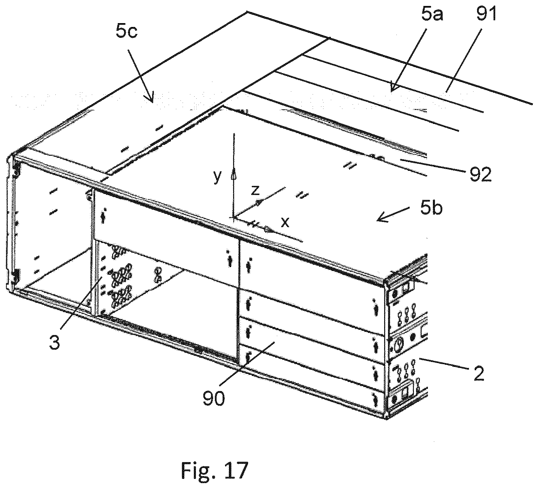

In Fig. 17 ist ein Kastengehäuse 1 mit den Teilbereichen 5a, 5b und 5c dargestellt. Im Teilbereich 5b sind mehrere erste Baugruppen 90 in z-Richtung eingeschoben. Im Bereich 92 befindet sich ein erstes Grundrechnermodul, das in y-Richtung ausgerichtet ist. Die ersten Baugruppen 90 sind über Stecker mit dem ersten Grundrechnermodul verbunden. Im Teilbereich 5a sind Steckplätze für zweite Baugruppen 91 dargestellt, die ebenfalls in y-Richtung eingeschoben werden und über Stecker in ein in z-Richtung am Boden des Teilbereichs angeordnetes zweites Grundrechnermodul, nicht dargestellt, eingesteckt werden. Die beiden Grundrechnermodule sind vorzugsweise ebenfalls durch Stecker miteinander verbunden.

Durch diese Einbaurichtung der ersten bzw. zweiten Baugruppe 90, 91 kann in x-Richtung sowohl zwischen den ersten Baugruppen 90 als auch den zweiten Baugruppen 91 ein Luftstrom hindurchtreten. Die in y-Richtung orientierten Seitenwände 2 und Trennwände 3 weisen eine Vielzahl von Öffnungen wie zum Beispiel die Führungsöffnungen 63 aber auch dedizierte Lüftungsöffnungen auf, sodass Luft in x-Richtung ein- bzw. ausströmen kann. Diese Anordnung ermöglicht somit eine effektive Belüftung der ersten sowie der zweiten Baugruppe sowie ihrer zugeordneten Grundrechnermodule.

Wird das Kastengehäuse beispielsweise für ein Hochfrequenzmessgerät verwendet, können digitale Baugruppen als erste Baugruppen 90 in Teilbereich 5b und analoge Schaltungen für die HF-Erzeugung bzw. Analyse als zweiten Baugruppen 91 in Teilbereich 5a untergebracht sein. Im Teilbereich 5c des Kastengehäuses 1 kann sich die Stromversorgungsbaugruppe des Geräts befinden.

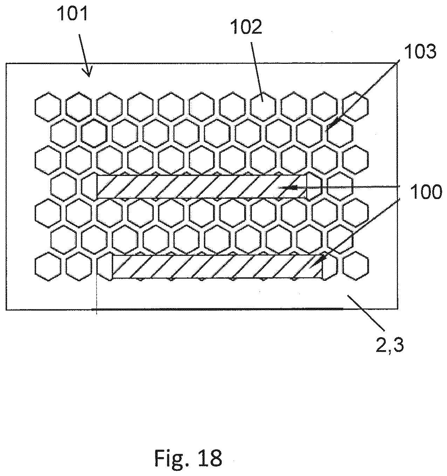

Fig. 18 zeigt eine Lüftungszone 101 einer Seiten- bzw. Trennwand 2, 3. Eine Vielzahl von Lüftungsöffnungen 102 sind dicht nebeneinander angeordnet und lediglich durch schmale Steg 103 voneinander getrennt. Die Lüftungsöffnungen 102 werden wie die meisten bisher beschriebenen Öffnungen oder Ausnehmungen durch Stanzen in das Edelstahlblech eingebracht. Um ein Aufwellen der Seiten- bzw. Trennwand 2, 3 zu vermeiden, wird eine Querprägung, das heißt senkrecht zur Ebene der Seiten- bzw. Trennwand, in diese eingebracht. Ein Prägestempel 100 wird dazu auf einen Teilbereich der Lüftungszone 101, die bevorzugt 8 Lüftungsöffnungen 102 umfasst, aufgesetzt. Diese Querprägung ist bevorzugt ca. 0,4 mm tief und wiederholt sich bevorzugt in jeder vierten Reihe der Lüftungsöffnungen 102.

Alle beschriebenen und/oder gekennzeichneten Merkmale können im Rahmen der Erfindung vorteilhaft miteinander kombiniert werden. Die Erfindung ist nicht auf die gezeigten Ausführungsbeispiele beschränkt.

## Patentansprüche

1. Kastengehäuse zum Einbau von elektronischen Baugruppen (90, 91) mit Seitenwänden (2), das eine Unterteilung in Teilbereiche (5a, 5b, 5c), die durch Trennwände (3, 3') begrenzt sind, aufweist,
wobei eine Seiten- und/oder eine Trennwand (2, 3) mehrere Führungsöffnungen (63) mit überstehenden Kragen (64) aufweist,
wobei die Führungsöffnungen (63) auf zwei parallelen Geraden in einem Abstand (a) voneinander, parallel zur Einschubrichtung (65) einer elektronischen Baugruppe (90, 91) an der Seiten- und/oder Trennwand (2, 3) angeordnet sind,
wobei das Kastengehäuse Rahmenelemente (4, 4', 17) aufweist,
wobei die Rahmenelemente (4, 4', 17) mindestens eine Ausnehmung (7) aufweisen, die Seitenwände (2) und/oder die Trennwände (3, 3') mindestens einen randseitigen Überstand (6) aufweisen, und
wobei der Überstand (6) in die Ausnehmung (7) eingreift, und der Überstand (6) und die Ausnehmung (7) durch Schweißen miteinander verbunden sind, wobei in einem ersten Teilbereich (5b) eine erste Baugruppe (90) oder mehrere erste Baugruppen (90) in einer ersten Richtung (z) parallel zur Ebene einer Seitenwand (2) bzw. Trennwand (3) eingeschoben sind und in einem zweiten Teilbereich (5a) eine zweite Baugruppe (91) oder mehrere zweite Baugruppen (91) in einer zweiten Richtung (y) parallel zur Ebene der Seitenwand (2) bzw. Trennwand (3) und senkrecht zu der ersten Richtung (z) der ersten Baugruppe (90) im ersten Teilbereich (5a) eingeschoben sind.

2. Kastengehäuse nach Anspruch 1,
**dadurch gekennzeichnet,**
**dass** der Kragen (64) einer Führungsöffnung (63) eine runde Kontur aufweist.

3. Kastengehäuse nach Anspruch 1 oder 2,
**dadurch gekennzeichnet,**
**dass** der Kragen (64) einstückig mit der Seiten- und/oder Trennwand (2, 3) ausgeführt ist.

4. Kastengehäuse nach einem der vorhergehenden Ansprüche,
**dadurch gekennzeichnet,**
**dass** mindestens ein Federelement (66) mit einer Seiten- und/oder Trennwand (2, 3) lösbar verbunden und so angeordnet ist, dass es in den durch die beabstandeten Führungsöffnungen (63, 63') begrenzten Bereich hineinragt.

5. Kastengehäuse nach Anspruch 4,
**dadurch gekennzeichnet,**
**dass** das Federelement (66) an einer Ausnehmung (69) der Seiten- und/oder Trennwand (2, 3) lösbar gehalten ist.

6. Kastengehäuse nach Anspruch 1,
**dadurch gekennzeichnet,**
**dass** zwischen dem Überstand (6) und einem Rand der Ausnehmung (7), in die der Überstand (6) eingreift, ein Zwischenraum (41) von weniger als 100µm Breite, bevorzugt weniger als 50pm Breite, gebildet ist.

7. Kastengehäuse nach Anspruch 1 oder 6,
**dadurch gekennzeichnet,**
**dass** eine Deckplatte und/oder Bodenplatte (8, 9) randseitig senkrecht von der Deckplatte (8) bzw. Bodenplatte (9) überstehende Haken (47) aufweist, und die Deckplatte (8) bzw. Bodenplatte (9) durch Einschieben der Haken (47) in Aufnahmeöffnungen (46) in den Seitenwänden (2) und/oder Trennwänden (3) mit den Seitenwänden (2) bzw. Trennwänden (3) verbunden ist.

8. Kastengehäuse nach Anspruch 7,
**dadurch gekennzeichnet,**
**dass** die Seiten- und/oder Trennwand (2, 3) mindestens einen ersten Stirnfalz (43) mit einem ersten (44) und zweiten (45) zueinander geneigten Schenkel aufweist und der erste Stirnfalz (43) im ersten Schenkel (44) die Aufnahmeöffnungen (46) für die Deck- bzw. Bodenplatte (8, 9) aufweist.

9. Kastengehäuse nach Anspruch 8,
**dadurch gekennzeichnet,**
**dass** die Seiten- und/oder Trennwand (2, 3) mindestens einen zweiten Stirnfalz (42) mit einem ersten (44, 48) und zweiten (45, 49) zueinander geneigten Schenkel aufweist, und ein Federband (50, 53, 54) zur elektromagnetischen Abdichtung lösbar mit dem zweiten Stirnfalz (42) der Seiten- und/oder Trennwand (2, 3) verbunden ist.

10. Kastengehäuse nach Anspruch 9,
**dadurch gekennzeichnet,**
**dass** das Federband (50, 53, 54) in mehrere Aufnahmeöffnungen an dem zweiten Schenkel (45, 49) des zweiten Stirnfalzes (42) gehalten ist.

11. Kastengehäuse nach einem der vorhergehenden Ansprüche,
**dadurch gekennzeichnet,**
**dass** mindestens eine Zentrierungsnase (80, 84) im Randbereich der Seiten- und/oder Trennwand (2, 3) angeordnet ist, in die eine Ausnehmung (83, 85) eines Baugruppengehäuses eingreift.

12. Kastengehäuse nach Anspruch 1,
**dadurch gekennzeichnet,**
**dass** die eine erste Baugruppe (90) oder mehrere erste Baugruppen (90) in ein erstes Grundrechnermodul eingesteckt ist bzw. sind,
**dass** die eine zweite Baugruppe (91) oder mehrere zweite Baugruppen (91) in ein zweites Grundrechnermodul eingesteckt ist bzw. sind und
**dass** das erste Grundrechnermodul parallel zur Steckrichtung der zweiten Baugruppe (91) sowie das zweite Grundrechnermodul parallel zur Steckrichtung der ersten Baugruppe (90) angeordnet ist.

13. Kastengehäuse nach Anspruch 12,
**dadurch gekennzeichnet,**
**dass** das erste Grundrechnermodul und das zweite Grundrechnermodul durch eine Steckverbindung miteinander verbunden sind.

14. Kastengehäuse nach einem der Ansprüche 1, 12 oder 13,
**dadurch gekennzeichnet,**
**dass** die Seitenwand (2) und/oder Trennwand (3) eine oder mehrere Lüftungszonen (101) mit jeweils einer Vielzahl von Lüftungsöffnungen (102) aufweist und ein Luftstrom in einer dritten Richtung (x) senkrecht zur ersten Richtung (z) und senkrecht zur zweiten Richtung (y) durch die Lüftungszonen (101) ein- bzw. ausblasbar ist.

15. Kastengehäuse nach Anspruch 14,
**dadurch gekennzeichnet,**
**dass** im Bereich der Lüftungszone (101) eine Querprägung quer zu einem Rand der Seiten- und/oder Trennwand (2, 3) und senkrecht zur Ebene der Seiten- bzw. Trennwand in die Seiten- und/oder Trennwand (2, 3) eingebracht wird.

## Claims

1. Box enclosure for installation of electronic assemblies (90, 91) with side walls (2), which has a subdivision into part regions (5a, 5b, 5c) which are bounded by partition walls (3, 3'),
wherein one side and/or one partition wall (2,3) has a plurality of guide openings (63) with projecting collars (64),
wherein the guide openings (63) are arranged on the side and/or partition wall (2, 3) on two parallel straight lines at a distance (a) from one another, parallel to the direction of insertion (65) of an electronic assembly (90, 91),
wherein the box enclosure has frame elements (4, 4', 17), wherein the frame elements (4, 4', 17) have at least one recess (7),
wherein the side walls (2) and/or the partition walls (3, 3') have at least one projection (6) at the edge, and wherein the projection (6) engages in the recess (7) and the projection (6) and the recess (7) are connected with one another by welding,
wherein in a first part region (5b) a first assembly (90) or a plurality of first assemblies (90) are inserted in a first direction (z) parallel to the plane of a side wall (2) or partition wall (3) and in a second part region (5a) a second assembly (91) or a plurality of second assemblies (91) are inserted in a second direction (y) parallel to the plane of the side wall (2) or partition wall (3) and perpendicular to the first direction (z) of the first assembly (90) in the first part region (5a).

2. Box enclosure according to claim 1,
**characterised in that**
the collar (64) of a guide opening (63) has a round contour.

3. Box enclosure according to claim 1 or 2,
**characterised in that**
the collar (64) is formed in one piece with the side and/or partition wall (2, 3).

4. Box enclosure according to one of the preceding claims,
**characterised in that**
at least one spring element (66) is detachably connected with a side and/or partition wall (2, 3) and arranged so that it projects into the region bounded by the spaced guide openings (63, 63').

5. Box enclosure according to claim 4,
**characterised in that**
the spring element (66) is detachably held in a recess (69) of the side and/or partition wall (2, 3).

6. Box enclosure according to claim 1,
**characterised in that**
a space (41) of less than 100 µm in width, preferably less than 50 µm in width, is formed between the projection (6) and one edge of the recess (7) in which the projection (6) engages.

7. Box enclosure according to claim 1 or 6,
**characterised in that**
a cover plate and/or a bottom plate (8, 9) have hooks (47) which project perpendicularly from the cover plate (8) or bottom plate (9) at the edge, and the cover plate (8) or bottom plate (9) is connected with the side walls (2) or partition walls (3) by inserting the hooks (47) into receiving openings (46) in the side walls (2) and/or partition walls (3).

8. Box enclosure according to claim 7,
**characterised in that**
the side and/or partition wall (2, 3) has at least one first front channel moulding (43) with a first limb (44) and a second limb (45) inclined at an angle to one another, and the first front channel moulding (43) has the receiving openings (46) for the cover or bottom plate (8, 9) in the first limb (44).

9. Box enclosure according to claim 8,
**characterised in that**
the side and/or partition wall (2, 3) has at least one second front channel moulding (42) with a first limb (44, 48) and second limb (45, 49) inclined at an angle to one another, and a spring strip (50, 53, 54) for electromagnetic sealing is connected detachably with the second front channel moulding (42) of the side and/or partition wall (2, 3).

10. Box enclosure according to claim 9,
**characterised in that**
the spring strip (50, 53, 54) is held in a plurality of receiving openings in the second limb (45, 49) of the second front channel moulding (42).

11. Box enclosure according to one of the preceding claims,
**characterised in that**
at least one centring lug (80, 84) is arranged in the edge region of the side and/or partition wall (2, 3) in which a recess (83, 85) of an assembly housing engages.

12. Box enclosure according to claim 1,
**characterised in that**
the one first assembly (90) or plurality of first assemblies (90) is/are plugged into a first basic computer module,
**in that** the one second assembly (91) or plurality of second assemblies (91) is/are plugged into a second basic computer module and
**in that** the first basic computer module is arranged parallel to the direction in which the second assembly (91) is plugged and the second basic computer module is arranged parallel to the direction in which the first assembly (90) is plugged.

13. Box enclosure according to claim 12,
**characterised in that**
the first basic computer module and the second basic computer module are connected with one another by a plug-in connection.

14. Box enclosure according to one of claims 1, 12 or 13,
**characterised in that**
the side wall (2) and/or partition wall (3) has one or more ventilation zones (101) each with a multiplicity of ventilation openings (102), and a stream of air can be blown in or out through the ventilation zones (101) in a third direction (x) perpendicular to the first direction (z) and perpendicular to the second direction (y).

15. Box enclosure according to claim 14,
**characterised in that**
in the region of the ventilation zone (101) a transverse embossed impression is formed in the side and/or partition wall (2, 3) transversely to one edge of the side and/or partition wall (2, 3) and perpendicularly to the plane of the side or partition wall

## Revendications

1. Boitier en forme de coffret destiné au montage de modules électroniques (90, 91), comprenant des parois latérales (2), et qui présente une subdivision en zones partielles (5a, 5b, 5c) délimitées par des parois de séparation (3, 3'),
boitier en forme de coffret
dans lequel une paroi latérale et/ou de séparation (2, 3) présente plusieurs ouvertures de guidage (63) avec des collerettes (64) en saillie,
dans lequel les ouvertures de guidage (63) sont agencées sur deux droites parallèles, à une distance d'espacement (a) l'une de l'autre, parallèlement à une direction d'insertion (65) d'un module électronique (90, 91), sur la paroi latérale et/ou de séparation (2, 3),
dans lequel sont prévus des éléments de châssis (4, 4', 17),
dans lequel les éléments de châssis (4, 4', 17) présentent au moins un évidement (7), et les parois latérales (2) et/ou les parois de séparation (3, 3') présentent sur le bord, au moins une saillie de bordure (6), et
dans lequel la saillie de bordure (6) vient en prise dans l'évidement (7), et la saillie de bordure (6) et l'évidement (7) sont reliés mutuellement par soudage,
et dans lequel dans une première zone partielle (5b) sont insérés un premier module (90) ou plusieurs premiers modules (90), dans une première direction (z) parallèlement au plan d'une paroi latérale (2) respectivement d'une paroi de séparation (3), et dans une deuxième zone partielle (5a) sont insérés un deuxième module (91) ou plusieurs deuxièmes modules (91), dans une deuxième direction (y), parallèlement au plan de la paroi latérale (2) respectivement de la paroi de séparation (3) et perpendiculairement à la première direction (z) du premier module (90) dans la première zone partielle (5a).

2. Boitier en forme de coffret selon la revendication 1,
**caractérisé**
**en ce que** la collerette (64) d'une ouverture de guidage (63) présente un contour rond.

3. Boitier en forme de coffret selon la revendication 1 ou la revendication 2,
**caractérisé**
**en ce que** la collerette (64) est réalisée d'un seul tenant avec la paroi latérale et/ou de séparation (2, 3).

4. Boitier en forme de coffret selon l'une des revendications précédentes,
**caractérisé**
**en ce qu'**au moins un élément de ressort (66) est relié de manière amovible à une paroi latérale et/ou de séparation (2, 3), et est agencé de manière à s'engager dans la zone délimitée par les ouvertures de guidage (63, 63') espacées.

5. Boitier en forme de coffret selon la revendication 4,
**caractérisé**
**en ce que** l'élément de ressort (66) est maintenu de manière amovible dans un évidement (69) de la paroi latérale et/ou de séparation (2, 3).

6. Boitier en forme de coffret selon la revendication 1,
**caractérisé**
**en ce qu'**entre la saillie de bordure (6) et un bord de l'évidement (7) dans lequel s'engage la saillie de bordure (6), est formé un espace intermédiaire (41) d'une largeur de moins de 100µm, de préférence d'une largeur de moins de 50pm.

7. Boitier en forme de coffret selon la revendication 1 ou la revendication 6,
**caractérisé**
**en ce qu'**une plaque de couvercle et/ou une plaque de fond (8,9) présente en bordure, des crochets (47), qui font saillie perpendiculairement de la plaque de couvercle (8) ou respectivement de la plaque de fond (9), et la plaque de couvercle (8) ou respectivement la plaque de fond (9) est reliée aux parois latérales (2) ou respectivement aux parois de séparation (3), par insertion des crochets (47) dans des ouvertures d'accueil (46) des parois latérales (2) et/ou des parois de séparation (3).

8. Boitier en forme de coffret selon la revendication 7,
**caractérisé**
**en ce que** la paroi latérale et/ou de séparation (2, 3) présente au moins une première feuillure frontale de pliage (43) avec une première (44) et une deuxième aile (45) inclinées l'une par rapport à l'autre, et la première feuillure frontale de pliage (43) présente, dans la première aile (44), les ouvertures d'accueil (46) pour la plaque de couvercle et respectivement la plaque de fond (8, 9).

9. Boitier en forme de coffret selon la revendication 8,
**caractérisé**
**en ce que** la paroi latérale et/ou de séparation (2, 3) présente au moins une deuxième feuillure frontale de pliage (42) avec une première (44, 48) et une deuxième aile (45, 49) inclinées l'une par rapport à l'autre, et une bande de ressort (50, 53, 54), pour assurer l'étanchéité électromagnétique, est reliée de manière amovible à la deuxième feuillure frontale de pliage (42) de la paroi latérale et/ou de séparation (2, 3).

10. Boitier en forme de coffret selon la revendication 9,
**caractérisé**
**en ce que** la bande de ressort (50, 53, 54) est maintenue dans plusieurs ouvertures d'accueil dans la deuxième aile (45, 49) de la deuxième feuillure frontale de pliage (42).

11. Boitier en forme de coffret selon l'une des revendications précédentes,
**caractérisé**
**en ce qu'**au moins un talon de centrage (80, 84) est agencé dans la zone de bordure de la paroi latérale et/ou de séparation (2, 3), et sur celui-ci vient s'engager un évidement (83, 85) d'un boitier de module.

12. Boitier en forme de coffret selon la revendication 1,
**caractérisé**
**en ce que** ledit un premier module (90) ou lesdits plusieurs premiers modules (90) est ou sont enfichés dans un premier module de calculateur de base,
**en ce que** ledit un deuxième module (91) ou lesdits plusieurs deuxièmes modules (91) est ou sont enfichés dans un deuxième module de calculateur de base, et
**en ce que** le premier module de calculateur de base est agencé parallèlement à la direction selon laquelle est enfiché le deuxième module (91), et le deuxième module de calculateur de base est agencé parallèlement à la direction selon laquelle est enfiché le premier module (90) .

13. Boitier en forme de coffret selon la revendication 12,
**caractérisé**
**en ce que** le premier module de calculateur de base et le deuxième module de calculateur de base sont reliés mutuellement par l'intermédiaire d'une connexion enfichable.

14. Boitier en forme de coffret selon la revendication 1, 12 ou la revendication 13,
**caractérisé**
**en ce que** la paroi latérale (2) et/ou de séparation (3) présente une ou plusieurs zones de ventilation (101) avec chacune un grand nombre d'ouvertures de ventilation (102), et un flux d'air peut être insufflé et respectivement soufflé à travers les zones de ventilation (101), selon une troisième direction (x) perpendiculaire à la première direction (z) et perpendiculaire à la deuxième direction (y) .

15. Boitier en forme de coffret selon la revendication 14,
**caractérisé**
**en ce que** dans la zone de ventilation (101), est réalisé un nervurage transversal de matriçage dans la paroi latérale et/ou de séparation (2, 3), transversalement à un bord de la paroi latérale et/ou de séparation (2, 3) et perpendiculairement au plan de la paroi latérale et/ou de séparation.
